# EUROPÄISCHE PATENTANMELDUNG

(11) **EP 1 777 786 A2**
(43) Veröffentlichungstag der Anmeldung: **25.04.2007**
(21) Anmeldenummer: 06120656.1
(22) Anmeldetag: 14.09.2006
(51) Int. Cl.: H01R 24/14, G02F 1/33

(54) **Zwischenglaskontaktelement**

(30) Priorität: 21.10.2005 DE 102005050545
(71) Anmelder: Escha Bauelemente GmbH, 58553 Halver (DE)
(72) Erfinder: Hübner, Klaus, 42929, Wermelskirchen (DE)
(74) Vertreter: Grundmann, Dirk

(57) **Zusammenfassung**

Die Erfindung betrifft ein Kontaktelement (1) für ein zwischen zwei Platten (19), insbesondere Glasplatten angeordnetes elektrisches Organ, insbesondere eine LC-Folie (22) oder eine Solarzellenanordnung, mit einer in den Plattenzwischenraum ragenden Kontaktfahne (5) und einem am Plattenrand (20) angeordneten Kunststoffgchäusc (2), in welchem die Kontaktfahne (5) mit einem elektrisch leitenden Mittel verbunden ist. Um das elektrische Organ zwischen den beiden Platten einfacher mit einer elektrischen Stromquelle zu verbinden, wird vorgeschlagen, dass das elektrisch leitende Mittel ein Kontaktstift (4) eines Einbausteckers (3) zum Einstecken eines mit einem Kabel (29) verbundenen Steckers (24) ist.

## Beschreibung

Die Erfindung betrifft zunächst ein Kontaktelement für ein zwischen zwei Platten, insbesondere Glasplatten, angeordnetes elektrisches Organ, insbesondere eine LC-Folie oder eine Solarzellenanordnung, mit einer in den Plattenzwischenraum ragenden Kontaktfahne und einem am Plattenrand angeordneten Kunststoffgehäuse, in welchem die Kontaktfahne mit einem elektrisch leitenden Mittel verbunden ist.

Im Stand der Technik sind Fenster bekannt, die aus zwei Glasplatten bestehen, in deren Zwischenraum eine LC-Folie angeordnet ist. An die LC-Folie werden direkt die Kabel angelötet, um die LC-Folie mit elektrischem Strom zu versorgen. Die LC-Folie liegt zwischen zwei Kontaktfolien, die elektrisch leitend sind. Jede dieser beiden Kontaktfolien ist mit einem Kontaktelement verbunden. Werden die beiden Kontaktfolien bestromt, so orientieren sich die Flüssigkristalle der LC-Folie anders. Dies hat zur Folge, dass eine transparente LC-Folie in einen opaken Zustand umschalten kann. Derartige Glasplatten können beispielsweise als Fensterscheiben oder als Raumteiler verwendet werden und bei Bedarf zwischen durchscheinend und durchsichtig umgeschaltet werden. Es ist ferner bekannt, zwischen Glasscheiben oder unter einer Glasscheibe Solarzellen oder andere elektrisch anzusteuernde Folien anzuordnen. Die Kontakte werden mittels Kontaktelementen nach außen geführt.

Der Erfindung liegt die Aufgabe zugrunde, das elektrische Organ zwischen den beiden Platten einfacher mit einer elektrischen Stromquelle zu verbinden.

Gelöst wird die Aufgabe sowohl von jedem einzelnen Anspruch alleine als auch von jedweder Kombination jedes Anspruches mit jedem beliebigen anderen Anspruch.

Der Anspruch 1 sieht zunächst und im Wesentlichen vor, dass das elektrisch leitende Mittel ein Kontaktstift eines Einbausteckers zum Einstecken eines mit einem Kabel verbundenen Steckers ist.

Der Kontaktstift weist ein in dem Kunststoffgehäuse eingespritztes Anschlussende auf, welches einen Längsschlitz aufweist, durch welchen das Ende der Kontaktfahne ragt. Das Ende der Kontaktfahne ist mit dem Kontaktstift verlötet. Der Kontaktstift und die Kontaktfahne weisen einen Winkel zueinander auf. Der Winkel kann bis zu 180° betragen, so dass Kontaktstift und Kontaktfahne fluchtend in einer Linie hintereinander angeordnet sind. Es ist auch möglich, dass der Kontaktstift und die Kontaktfahne im wesentlichen in einem rechten Winkel zueinander stehen. Der Kontaktstift verläuft parallel zur Plattenebene und zum Plattenrand. Das Kunststoffgehäuse besteht aus einem weichen Kunststoff. Der Kontaktstift steckt in einem aus einem härteren Kunststoff bestehenden Einbaustecker ein. Der Einbaustecker weist eine Einstecköffnung für ein Steckerteil auf. Ein Kontaktabschnitt des Kontaktstiftes ragt aus dem Boden der Einstecköffnung heraus. Die Außenwandung der topfförmigen Einstecköffnung weist einen radial nach außen weisenden umlaufenden Wulst auf, welcher von einem Schnappkragen des Steckerteils überfangbar ist. Das Gehäuse bildet einen Schmalfortsatz aus, der zur Fixierung des Gehäuses im Plattenzwischenraum dient. Der Schmalfortsatz umgibt zumindest teilweise die Kontaktfahne. Das Kunststoffgehäuse wird im Spritzgussverfahren hergestellt, wobei der Einbaustecker mit umspritzt wird. So entsteht eine im Wesentlichen formschlüssige Verbindung zwischen Einbaustecker und Weichkunststoffgehäuseabschnitt.

Des Weiteren betrifft die Erfindung einen zwischen zwei parallel zueinander angeordneten Glasplatten einliegendes elektrisches Organ, insbesondere LC-Folie oder Solarzellenanordnung mit mindestens einem Kontaktelement mit einem oder mehreren der genannten Merkmale.

Die Erfindung wird anhand eines Ausführungsbeispiels nachfolgend näher erläutert. Es zeigen:
- Fig. 1: eine Vorderansicht eines Kontaktelementes, welches teilweise im Schnitt dargestellt worden ist;
- Fig. 2: einen Schnitt entlang der Linie II - II aus Fig. 1, wobei jedoch ein Stecker dargestellt worden ist, der mit dem Einbaustecker verbunden ist;
- Fig. 3: eine Ansicht des Kontaktelementes entsprechend der Blickrichtung III aus Fig. 1, wobei das Kontaktelement zwischen zwei Platten angeordnet ist;
- Fig. 4: einen Schnitt entlang der Linie IV - IV aus Fig. 1.
- Fig. 5: die Seitenansicht des Kontaktelementes, wobei die Glasplatte gestrichelt dargestellt ist und
- Fig. 6: eine um 90° gewendete Ansicht gemäß Fig. 5.

Das Kontaktelement 1 besteht im Wesentlichen aus einem Kunststoffgehäuse 2, einem Einbaustecker 3, einem elektrisch leitenden Mittel, welches von einem Kontaktstift 4 gebildet ist, und einer Kontaktfahne 5.

Der Einbaustecker 3 weist eine im Wesentlichen zylindrische Grundkontur auf und wird aus einem harten Kunststoff wie beispielsweise Polyamidguss (PAG) hergestellt. In dem Einbaustecker 3 liegt der Kontaktstift 4 ein. Der Kontaktstift 4 wird formschlüssig in dem Einbaustecker 3 gehalten. Der Kontaktstift 4 kann umspritzt werden oder wird anschließend formschlüssig mit dem Einbaustecker 3 verbunden. Der Kontaktstift 4 ist beispielsweise in den Einbaustecker 3 eingesteckt. Dies kann von der Rückseite her erfolgen. Hierzu bildet der Einbaustecker 3 einen gestuften zentralen Kanal aus, der im Boden 7 mündet. Der Kontaktstift 4 besitzt eine entsprechende Stufung.

Der Einbaustecker 3 bildet eine Einstecköffnung 6 aus. Diese weist eine topfförmige Gestalt auf. Die Einstecköffnung 6 bildet einen Boden 7 aus, durch den ein Kontaktabschnitt 8 des Kontaktstiftes 4 in die Einstecköffnung 6 hineinragt. Der Kontaktabschnitt 8 schließt in etwa mit der Stirnfläche des Einbausteckers 3 ab. Die Einstecköffnung 6 wird von einer Außenwandung 9 umragt. Die Außenwandung 9 bildet eine radial nach außen weisende umlaufende Wulst 10 aus. Der Einbaustecker 3 weist einen Endabschnitt 11 auf, der in dem Kunststoffgehäuse 2 einliegt. Der Endabschnitt 11 weist eine umlaufende Ringnut 12 auf. Aus der Stirnseite des Endabschnitts 11 ragt ein Anschlussende 13 des Kontaktstiftes 4 heraus.

Das Anschlussende 13 des Kontaktstiftes 8 weist einen Längsschlitz 14 auf. Der Längsschlitz 14 erstreckt sich in etwa über die gesamte Erstreckung des Endabschnittes 11. Die Breite des Längsschlitzes 14 ist der Dicke der Kontaktfahne 5 angepasst.

Die Kontaktfahne 5 kann eine klebende Seite 15 aufweisen. Die klebende Seite 15 wird im Anlieferungszustand des Kontaktelementes 1 von einer hier nicht dargestellten Schutzfolie geschützt. Ein Ende 16 der Kontaktfahne 5 ragt durch den Längsschlitz 14 des Kontaktstiftes 4 hindurch. Die Breite des Längsschlitzes 14 ist der Breite des Endes 16 der Kontaktfahne 5 angepasst. Die Kontaktfahne 5 wird mit dem Kontaktstift 4 verlötet. Die Lötnähte 17 werden von beiden Seiten der Kontaktfahne 5 angebracht. In dem Ausführungsbeispiel weisen die Kontaktfahne 5 und der Kontaktstift 4 in etwa einen rechten Winkel zueinander auf. Die Kontaktfahne 5 und der Kontaktstift 4 können auch einen anderen Winkel zueinander aufweisen. Der Längsschlitz 14 besitzt eine Länge, die größer ist als die Breite des insbesondere aus Kupfer oder einem anderen Metall bestehenden Streifens 15.

Der Einbaustecker 3 mit dem Kontaktstift 4 und der Kontaktfahne 5 werden von dem Kunststoffgehäuse 2 aufgenommen. Das Kunststoffgehäuse 2 wird in einem Spritzgussverfahren hergestellt. Es wird beispielsweise aus einem weichen Kunststoff wie thermoplastische Polyurethane (TPU) hergestellt. Der Einbaustecker 3 mit dem Kontaktstift 4 und die Kontaktfahne 5 sind mit dem Kunststoffgehäuse 2 formschlüssig verbunden. Durch die Ringnut 12 wird der Formschluss zwischen dem Einbaustecker 3 und dem Kunststoffgehäuse 2 verbessert.

Das Kunststoffgehäuse 2 bildet einen Schmalfortsatz 18 aus. Der Schmalfortsatz 18 umragt teilweise die Kontaktfahne 5. Dieser dient zur Stabilisierung der Kontaktfahne 5. In diesem Ausführungsbeispiel hat der Schmalfortsatz 18 eine im Querschnitt rechteckige Gestalt. Das Rechteck ist langgestreckt. Es wäre auch eine andere Form für den Schmalfortsatz 18 denkbar.

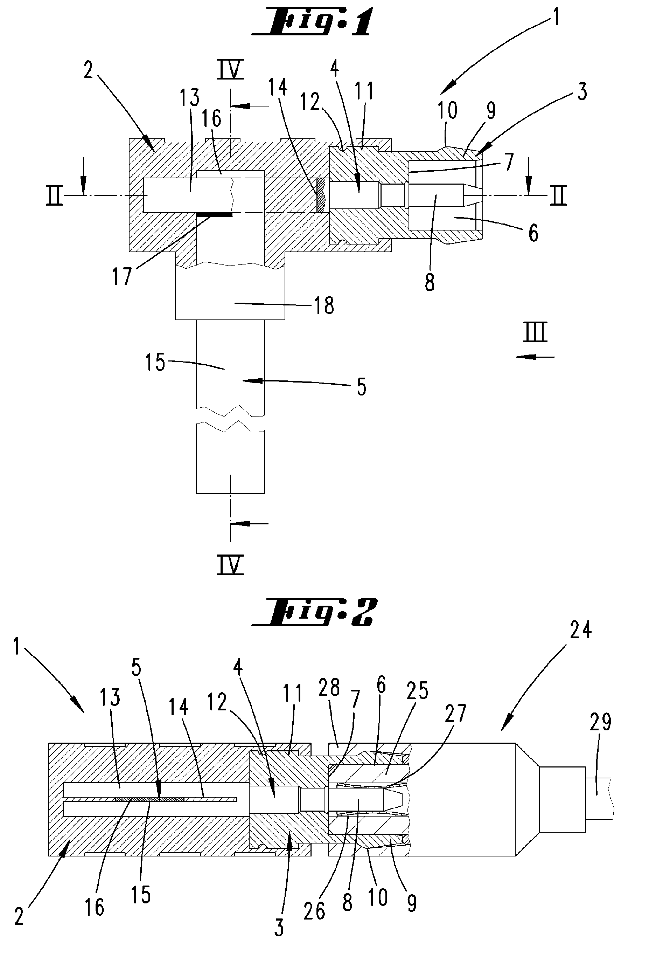

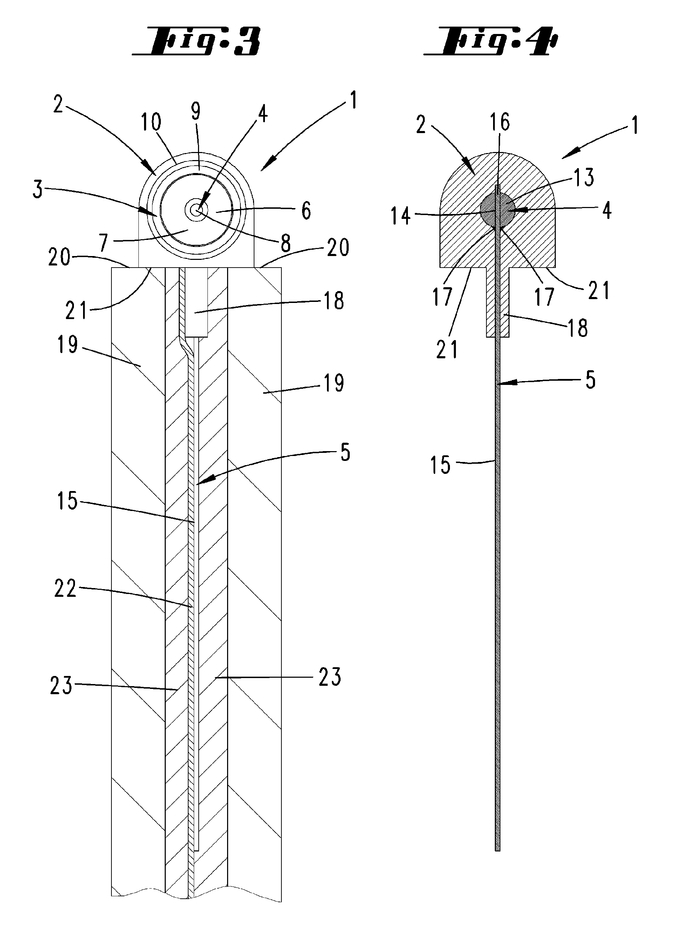

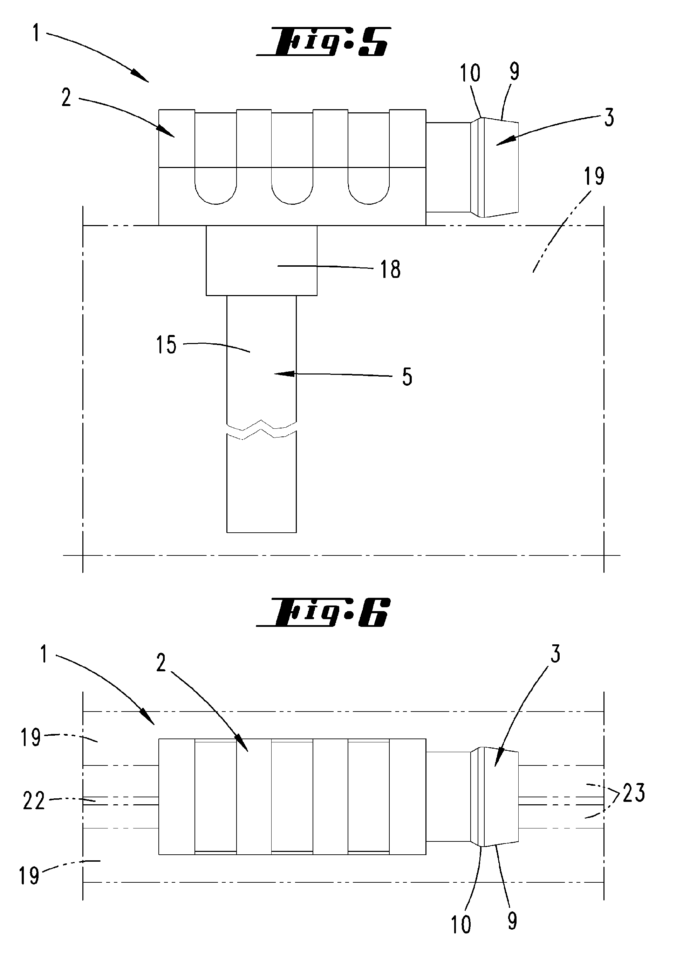

Wie in der Figur 3 zu sehen ist, wird das Kontaktelement 1 teilweise zwischen zwei Platten 19 angeordnet. Dabei ragt der Schmalfortsatz 18 in den Zwischenraum zwischen den beiden Platten 19 hinein. Das Kunststoffgehäuse 2 des Kontaktelementes 1 liegt dabei auf dem Plattenrand 20 der Platten 19 auf. Damit das Kontaktelement 1 richtig auf dem Plattenrand 20 aufliegen kann, bildet das Kunststoffgehäuse 2 eine Auflagefläche 21 aus. Die Auflagefläche 21 verläuft parallel zum Plattenrand 20. Durch die Auflage des Kontaktelements 1 auf dem Plattenrand 20 wird erreicht, dass der Kontaktstift 4 parallel zum Plattenrand 20 und zur Plattenebene verläuft. Die Kontaktfahne 5 wird in etwa mittig in dem Zwischenraum der beiden Platten 19 angeordnet. An der klebenden Seite 15 der Kontaktfahne 5 liegt ein elektrisches Organ zum Beispiel eine Kontaktfolie einer LC-Folie 22 an. Die Kontaktfolie der LC-Folie 22 ist über die Kontaktfahne 5 mit dem Kontaktstift 4 elektrisch leitend verbunden. Der Schmalfortsatz 18 sowie die Kontaktfahne 5 und die LC-Folie 22 werden von einer Laminierfolie 23 umschlossen. Das Kontaktelement 1 wird mit den beiden Platten 19, der LC-Folie 22 und der Laminierfolie 23 bei ca. 105° C unter Vakuum gebacken.

Die LC-Folie 22 kann mittels eines Steckers 24 (siehe Figur 2) mit einer Stromquelle verbunden werden. Der Stecker 24 weist einen Einsteckabschnitt 25 auf. Der Einsteckabschnitt 25 ist der Form der Einstecköffnung 6 formangepasst. Der Einsteckabschnitt 25 bildet eine Aufnahmeöffnung 26 für den Kontaktabschnitt 8 des Kontaktstiftes 4 aus. In der Aufnahmeöffnung 26 sind Steckbuchsen 27 angeordnet. Im eingesteckten Zustand des Steckers 24 liegen die Steckbuchsen 27 an dem Kontaktabschnitt 8 des Kontaktstiftes 4 an. Der Stecker 24 bildet einen Schnappkragen 28 aus. Der Schnappkragen 28 wirkt mit der umlaufenden Wulst 10 des Einbausteckers 3 zusammen. Durch den Schnappkragen 28 wird der Stecker 24 an dem Einbaustecker 3 fixiert. Rückwärtig des Steckers 24 entspringt ein Kabel 29. Das Kabel 29 kann mit einer Stromquelle verbunden werden. Des Weiteren sind die Steckbuchsen 27 mit dem Kabel 29 elektrisch leitend verbunden. Mittelst des Steckers 24 wird die LC-Folie 22 mit einer Stromquelle verbunden. Die Verbindung zwischen Stecker 24 und dem Einbaustecker 3 ist bevorzugt wasserdicht.

Durch die Steckerverbindung wird erreicht, dass keine aufwändigen Lötarbeiten am Einsatzort eines derartigen Fensters mit einer LC-Folie 22 nötig sind. Das Fenster wird einfach mit dem Stecker 24 verbunden.

Die Laminierfolien 23 erstrecken sich in Flächenanlage an der nach innen weisenden Breitseite der Glasplatte 19. Zwischen den Laminierfolien 23 liegt im Ausführungsbeispiel die LC-Folie 22, die beidseitig Kontaktfolien aufweist. Die Kontaktfolien sind elektrisch leitend und jeweils mit einem Kontaktelement 1 in der zuvor beschriebenen Weise verbunden. Die Laminierfolien 23 besitzen eine derartige Elastizität, dass sie den Schmalfortsatz 18 zwischen sich aufnehmen, der breiter ist als die Kontaktfahne 5. Der oben erwähnte Kleber ist elektrisch leitend, so dass Strom über die Kontaktfahne 5 in die nicht dargestellte Kontaktfolie fließen kann.

Wie bereits oben erwähnt, besitzt die LC-Folie 22 die Eigenschaft, sich bei angelegter Spannung oder fließendem Strom optisch zu verändern. Eine unbestromte LC-Folie 22 kann beispielsweise transparent sein. Durch die beim Anlegen einer Spannung sich umorientierenden Flüssigkristalle in der LC-Folie 22 wird diese dann opak oder dunkler. Es ist auch vorgesehen, dass die LC-Folie 22 im nicht bestromten Zustand opak ist und nur bei angelegter elektrischer Spannung transparent ist. Letzteres ist der bevorzugte Fall.

Es ist darüber hinaus möglich, das erfindungsgemäße Kontaktelement 1 bei einem Solarpaneel anzuwenden. Bei einem derartigen Solarpaneel sind auf einer im wesentlichen undurchsichtigen unteren Platte eine Vielzahl von Solarelementen angeordnet, die jeweils über elektrische Leitungen miteinander verbunden sind. Diese sind mit einer Deckplatte abgedeckt. Das Kontaktelement 1 kann dazu verwendet werden, hier die erforderlichen Kontakte nach außen zu führen.

Alle offenbarten Merkmale sind (für sich) erfindungswesentlich. In die Offenbarung der Anmeldung wird hiermit auch der Offenbarungsinhalt der zugehörigen/beigefügten Prioritätsunterlagen (Abschrift der Voranmeldung) vollinhaltlich mit einbezogen, auch zu dem Zweck, Merkmale dieser Unterlagen in Ansprüche vorliegender Anmeldung mit aufzunehmen.

## Patentansprüche

1. Kontaktelement (1) für ein zwischen zwei Platten (19), insbesondere Glasplatten angeordnetes elektrisches Organ, insbesondere eine LC-Folie (22) oder eine Solarzellenanordnung, mit einer in den Plattenzwischenraum ragenden Kontaktfahne (5) und einem am Plattenrand (20) angeordneten Kunststoffgehäuse (2), in welchem die Kontaktfahne (5) mit einem elektrisch leitenden Mittel verbunden ist, **dadurch gekennzeichnet, dass** das elektrisch leitende Mittel ein Kontaktstift (4) eines Einbausteckers (3) zum Einstecken eines mit einem Kabel (29) verbundenen Steckers (24) ist.

2. Kontaktelement nach Anspruch 1 oder insbesondere danach, **dadurch gekennzeichnet, dass** der Kontaktstift (4) ein in dem Kunststoffgehäuse (2) eingespritztes Anschlussende (13) aufweist, welches einen Längsschlitz (14) aufweist, durch welchen das Ende (16) der Kontaktfahne (5) ragt.

3. Kontaktelement nach einem oder mehreren der vorhergehenden Ansprüche oder insbesondere danach, **dadurch gekennzeichnet, dass** das Ende (16) der Kontaktfahne (5) mit dem Kontaktstift (4) verlötet ist.

4. Kontaktelement nach einem oder mehreren der vorhergehenden Ansprüche oder insbesondere danach, **dadurch gekennzeichnet, dass** Kontaktstift (4) und Kontaktfahne (5) einen Winkel zueinander aufweisen.

5. Kontaktelement nach einem oder mehreren der vorhergehenden Ansprüche oder insbesondere danach, **dadurch gekennzeichnet, dass** Kontaktstift (4) und Kontaktfahne (5) einander im Wesentlichen rechtwinklig zugeordnet sind.

6. Kontaktelement nach einem oder mehreren der vorhergehenden Ansprüche oder insbesondere danach, **dadurch gekennzeichnet, dass** der Kontaktstift (4) parallel zur Plattenebene und zum Plattenrand (20) verläuft.

7. Kontaktelement nach einem oder mehreren der vorhergehenden Ansprüche oder insbesondere danach, **dadurch gekennzeichnet, dass** das Kunststoffgehäuse (2) aus weicherem Kunststoff besteht und der Kontaktstift (4) in einem aus einem härteren Kunststoff bestehenden Einbaustecker (3) einsteckt.

8. Kontaktelement nach einem oder mehreren der vorhergehenden Ansprüche oder insbesondere danach, **dadurch gekennzeichnet, dass** der Einbaustecker (3) eine Einstecköffnung (6) für ein Steckerteil (24) aufweist.

9. Kontaktelement nach einem oder mehreren der vorhergehenden Ansprüche oder insbesondere danach, **dadurch gekennzeichnet, dass** ein Kontaktabschnitt (8) des Kontaktstiftes (4) aus dem Boden (7) der Einstecköffnung (6) ragt.

10. Kontaktelement nach einem oder mehreren der vorhergehenden Ansprüche oder insbesondere danach, **dadurch gekennzeichnet, dass** die Außenwandung (9) der topfförmigen Einstecköffnung (6) einen radial nach außen weisenden umlaufenden Wulst (10) aufweist, welcher von einem Schnappkragen (28) des Steckerteiles (24) überfangbar ist.

11. Kontaktelement nach einem oder mehreren der vorhergehenden Ansprüche oder insbesondere danach, **dadurch gekennzeichnet, dass** das Gehäuse (2) einen Schmalfortsatz (18) ausbildet, zur Fixierung des Gehäuses (2) im Plattenzwischenraum.

12. Kontaktelement nach einem oder mehreren der vorhergehenden Ansprüche oder insbesondere danach, **dadurch gekennzeichnet, dass** der Schmalfortsatz (18) zumindest teilweise die Kontaktfahne (5) umgibt.

13. Kontaktelement nach einem oder mehreren der vorhergehenden Ansprüche oder insbesondere danach, **dadurch gekennzeichnet, dass** das Kunststoffgehäuse (2) im Spritzgussverfahren hergestellt ist, wobei der Einbaustecker (3) mit umspritzt ist.

14. Kontaktelement nach einem oder mehreren der vorhergehenden Ansprüche oder insbesondere danach, **gekennzeichnet durch** eine im Wesentlichen formschlüssige Verbindung zwischen Einbaustecker (3) und Weichkunststoffgehäuseabschnitt (2).

15. Zwischen zwei parallel zueinander angeordneten Glasplatten (19) einliegendes elektrisches Organ, insbesondere LC-Folie (22) oder Solarzellenanordnung mit mindestens einem Kontaktelement (1) nach einem oder mehreren der vorhergehenden Ansprüche.
